# EUROPÄISCHE PATENTSCHRIFT

(11) **EP 0 569 894 B1**
(45) Veröffentlichungstag und Bekanntmachung des Hinweises auf die Patenterteilung: **08.01.1997**
(21) Anmeldenummer: 93107513.9
(22) Anmeldetag: 08.05.1993
(51) Int. Cl.: H03K 3/023, H03K 5/153

(54) **Schaltungsanordnung zur Erzeugung rechteckförmiger Signale**
Circuit arrangement for generating rectangular signals
Circuit pour générer des signaux rectangulaires

(30) Priorität: 15.05.1992 DE 4215811; 18.05.1992 DE 4216022
(43) Veröffentlichungstag der Anmeldung: 18.11.1993
(73) Patentinhaber: Deutsche Thomson-Brandt GmbH, 78003 Villingen-Schwenningen (DE)
(72) Erfinder: Gleim, Günter, W-7730 VS-Villingen (DE); Heizmann, Friedrich, W-7730 VS-Obereschach (DE); Link, Hermann, W-7730 VS-Obereschach (DE)

(56) Entgegenhaltungen:
- DE-A- 2 826 126
- US-A- 3 916 328

## Beschreibung

Die vorliegende Erfindung betrifft eine Schaltungsanordnung zur Erzeugung rechteckförmiger Signale aus sinusförmigen Signalen mit Hilfe mit einer Hysterese behafteten Komparatorschaltung.

Es ist bekannt, aus einem sinusförmigen Signal ein rechteckförmiges Signal zu erzeugen, welches genau in den Nulldurchgängen des sinusförmigen Signals steile Flanken besitzt. Ein derartiges Signal wird z.B. zum Schalten von elektronischen Stufen geeignet, weil es eine eindeutige Schaltfunktion darstellt. Ein ideal rechteckförmiges Signal entsteht jedoch nur bei ungestörten Eingangssignalen, bei denen also keine Störschwingungen überlagert sind. Diese verursachen bekanntlich in der Umgebung der Nulldurchgänge mehrere Flanken, die mit einem Prellen eines mechanischen Schaltkontaktes vergleichbar sind. Dadurch ist eine eindeutige Schaltfunktion nicht mehr gewährleistet. Um diesen Nachteil zu beseitigen, ist es bekannt, dem Komparator, an dem die rechteckförmigen Ausgangssignale entstehen, mit einer Schalthysterese zu versehen, wie dies z.B. in dem Buch von Tietze/Schenk, 4.Auflage, Seite 133/134 beschrieben ist. Durch diese Schalthysterese wird erst dann eine eindeutige Schaltflanke erzeugt, wenn ein oberer Mindestwert der Eingangsspannung überschritten, bzw. wenn ein unterer Mindestwert der Eingangsspannung unterschritten wird. Damit wird aber in Kauf genommen, daß die Schaltflanken des rechteckförmigen Ausgangssignals mit den Nulldurchgängen des Eingangssignals zeitlich nicht mehr zusammenfallen.

Deshalb liegt der Erfindung die Aufgabe zugrunde, eine Schaltungsanordnung anzugeben, die die Forderung erfüllt, daß die Flanken des Ausgangssignals mit den Nulldurchgängen des Eingangssignals übereinstimmen und Störungen des Eingangssignals kein Prellen am Ausgang verursachen. Diese Aufgabe wird durch die Maßnahme des Patentanspruchs 1 gelöst. Weitere Ausgestaltungen ergeben sich aus den abhängigen Ansprüchen. Aus Dokument DE-A-2 826 126 ist eine Schaltungsanordnung gemäß Oberbegriff des Anspruchs 1 bekannt.

Nachstehend wird die Erfindung an Ausführungsbeispielen mit Hilfe der Zeichnung beschrieben.
- Figur 1: zeigt ein erstes Schaltungsbeispiel
- Figur 2: zeigt Signale an den in Figur 1 gekennzeichneten Punkten
- Figur 3: zeigt ein weiteres Schaltungsbeispiel
- Figur 4: zeigt Signale an den in Figur 3 gekennzeichneten Punkten
- Figur 5: zeigt ein weiteres Ausführungsbeispiel der Erfindung.

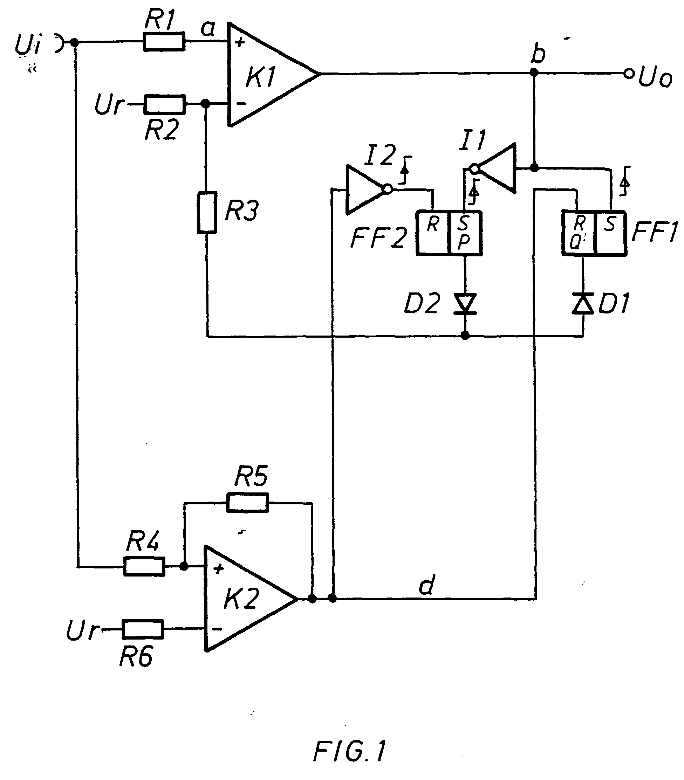

In Figur 1 ist das sinusförmige Eingangssignal Ui über einen Widerstand R1 an den (+)Eingang eines ersten Komparators K1 gelegt, an dessen Ausgang das rechteckförmige Ausgangssignal Uo entsteht. An den (-)Eingang des ersten Komparators K1 ist über einen Widerstand R2 eine Referenzspannung Ur gelegt. Der erste Komparator K1 ist mit einer über den Widerstand R3 zu-und abschaltbaren Hysterese versehen. An den Ausgang des ersten Komparators K1 sind zwei flankengetriggerte RS-Flip-Flops FF1 und FF2 parallelgeschaltet, wobei das Ausgangssignal Uo an den Setzeingang S des Flip-Flop FF1 direkt und an den Setzeingang des Flip-Flop FF2 über einen Inverter I1 geschaltet ist.
Der Q'-Ausgang des Flip-Flop FF1 ist über die Katoden-Anoden-Strecke einer Diode D1 und den Widerstand R3 mit dem (-)Eingang des ersten Komparators K1 verbunden. Der P-Ausgang des Flip-Flop FF2 ist über die Anoden-Katoden-Strecke einer Diode D2 und den Widerstand R3 mit dem (-)Eingang verbunden.

Das sinusförmige Eingangssignal Ui ist weiterhin über einen Widerstand R4 mit dem (+)Eingang eines zweiten Komparators K2 verbunden, dessen Ausgang über den Widerstand R5 auf den (+)Eingang zur Bildung einer Schalthysterese rückgekoppelt ist. An den (-)Eingang des zweiten Komparators K2 liegt wieder die Referenzspannung Ur. Der Ausgang des Komparators K2 ist erstens direkt mit dem Rücksetzeingang R des ersten Flip-Flop FF1 und über einen Inverter I2 mit dem Rücksetzeingang R des zweiten Flip-Flop FF2 verbunden.

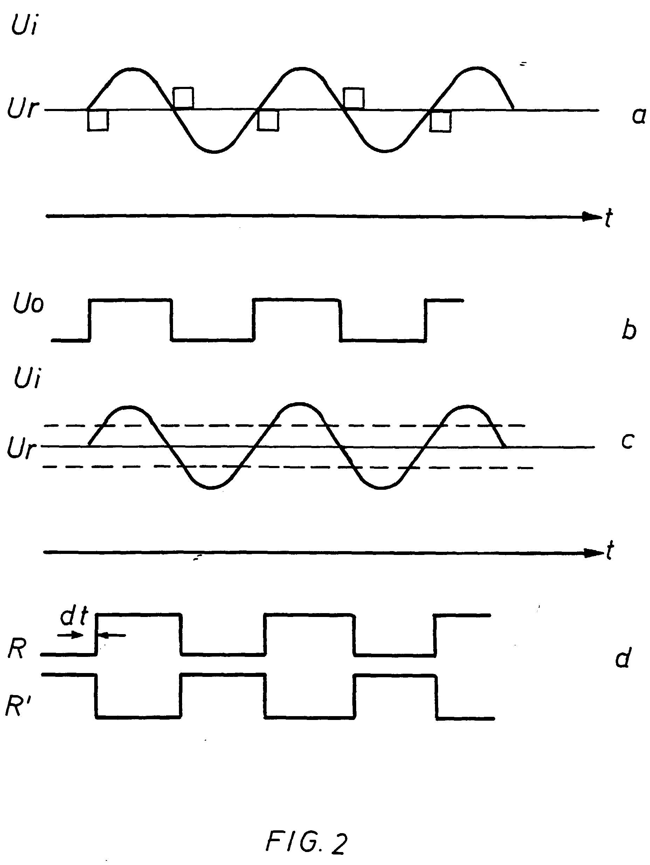

Die Wirkungsweise der Schaltung nach Figur 1 wird nachstehend in Verbindung mit den Signalen nach Figur 2 verständlich.

In Figur 2 sind die Signale a bis d bezeichnet, die an den entsprechenden Punkten der Schaltung in Figur 1 anliegen. Zunächst schaltet der Komparator K1 ohne Hysterese beim Nulldurchgang des Eingangssignals Ui (a) das Ausgangssignal Uo hoch (b). Dieses Signal setzt gleichzeitig das Flip-Flop FF1, so daß die Diode D1 am Q'-Ausgang das Potential am (-)Eingang und damit die Schaltschwelle herunterzieht. Das Ausgangssignal des zweiten Komparators K2 geht durch die Hysterese (c) erst später hoch (d). Die erste positive Flanke setzt das erste Flip-Flop FF1 Wieder zurück und hebt damit die Hysterese für den Komparator K1 auf, so daß dieser genau im nachfolgenden Nulldurchgang des Eingangssignals zurückgeschaltet wird. über den Inverter I1 wird das zweite Flip-Flop FF2 gesetzt, wodurch der P-Ausgang über die Diode D2 das Potential am (-)Eingang des Komparators K1 und damit die Schaltschwelle anhebt. Nach der durch die Hysterese des zweiten Komparators K2 bedingten später eintreffenden negativen Flanke wird diese Schaltschwelle des Komparators K1 durch das Zurücksetzen des Flip-Flop FF2 wieder zurückgeschaltet.

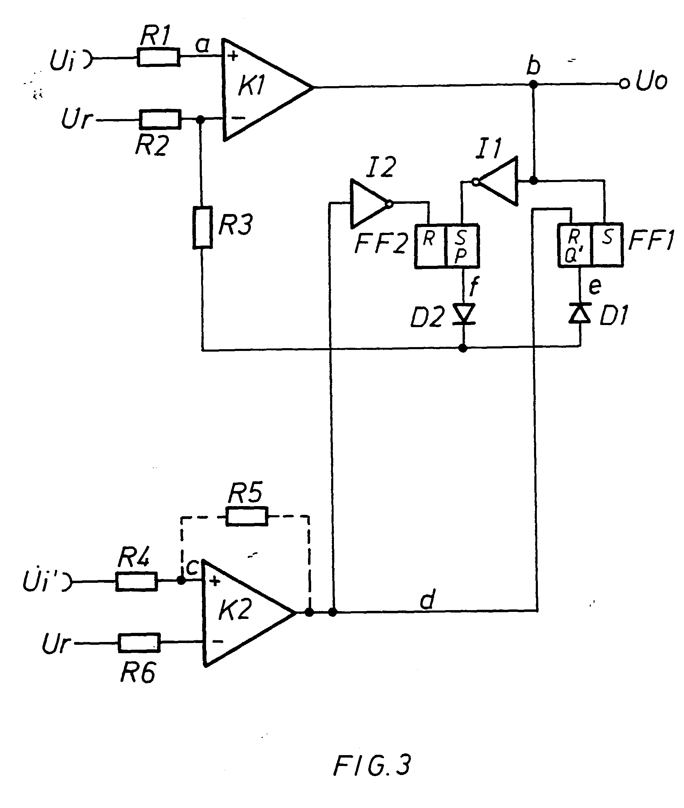

In Figur 3 ist ein weiteres Schaltungsbeispiel gezeigt, welches in ähnlicher Weise wirkt. Hier ist ein zweites Eingangssignal Ui' an den zweiten Komparator K2 mit fest eingestell ter oder ohne Hysterese angeschaltet, welches oftmals ohnehin zur Verfügung steht und zum ersten Eingangssignal in einer festen Phasenbeziehung steht. Im Beispiel ist ein um 90 Grad phasenverschobenes Signal angenommen. Die Wirkungsweise der Schaltung entspricht der in Figur 1 erläuterten Schaltung. Auch hier wird die mit dem Nulldurchgang des Eingangssignals zugeschaltete Hysterese jeweils durch das zweite Signal noch vor Eintreffen des nächsten Nulldurchgangs wieder zurückgeschaltet.

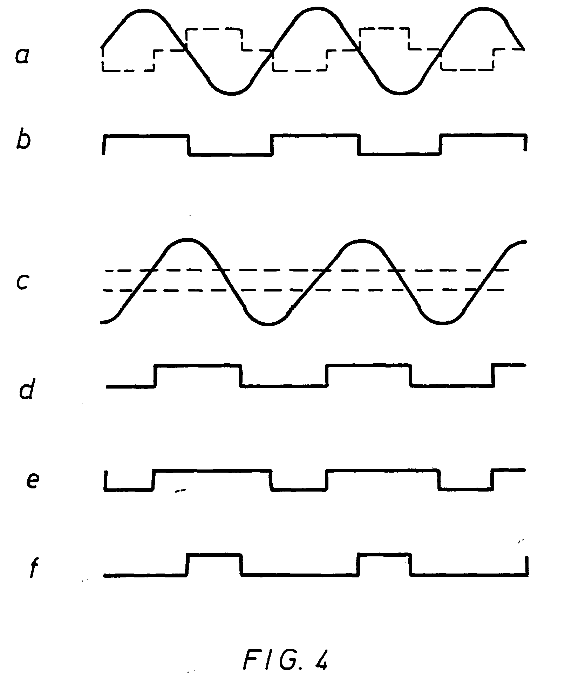

Figur 4 dient wieder zur Verdeutlichung der Wirkungsweise der Schaltung nach Figur 3 und ist mit seinen Signalen a bis f an den entsprechenden Stellen der Schaltung eingetragen.

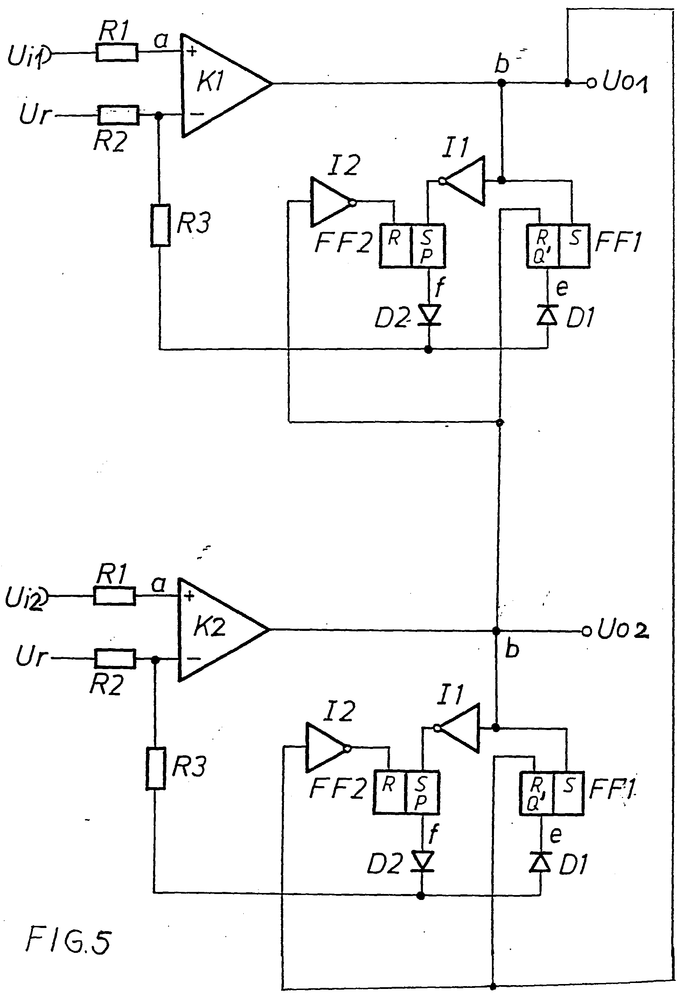

In Figur 5 ist ein weiteres Schaltungsbeispiel gezeigt, bei welchem zwei Ausgangsspannungen Uo1 und Uo2 aus zwei Eingangsspannungen Ui1 und Ui2 erzeugt werden, die an zwei in Kaskade geschaltete Komparatorschaltungen K1 und K2 gelegt sind, deren Hysterese ein- uns abschaltbar ist. Hierbei schaltet jeweils die Ausgangsspannung Uo1 bzw. Uo2 die Hysterese der Komparatorschaltung K1 bzw. K2 ein und die Ausgangsspannung Uo2 der Komparatorschaltung K2, bzw. die Ausgangsspannung Uo1 der Komparatorschaltung K1 die Hysterese der Komparatorschaltung K1 bzw. der Komparatorschaltung K2 wieder ab. Die Schaltung hat den Vorteil, daß zur Erzeugung zweier Ausgangsspannungen, deren Nulldurchgänge genau mit den Nulldurchgängen der Eingangsspannungen übereinstimmen, nur zwei Komparatorschaltungen notwendig sind.
Man kann die Schaltung dahingehend erweitern, daß mehrere Ausgangsspannungen Uo in phasenverschobener zyklischer Reihenfolge derart erzeugt werden, daß die phasenverschobenen Eingangsspannungen Uix an je eine Komparatorschaltung Kx geschaltet sind, wobei wiederum jede Ausgangsspannung Uox der Komparatorschaltung Kx die Hysterese der Komparatorschaltung Kx einschaltet und die Ausgangsspannung Uo(x+1) der folgenden Komparatorschaltung K(x+1) die Hysterese der vorhergehenden Komparatorschaltung Kx wieder abschaltet. Die Ausgangsspannung Uo(n) der Komparatorschaltung Kn (d.h., wenn x=n) schaltet die eigene Hysterese ein und die Hysterese der Komparatorschaltung K1 wieder ab.

## Patentansprüche

1. Schaltungsanordnung zur Erzeugung rechteckförmiger Signale mit Hilfe einer mit Hysterese behafteten Komparatorschaltung, deren Hysterese zu- und abschaltbar ist, wobei die Hysterese in den Nulldurchgängen des Eingangssignals zugeschaltet und vor Eintreffen des nachfolgenden Nulldurchgangs wieder abgeschaltet wird, und wobei ein Eingangssignal (Ui) an den Eingang einer mit schaltbarer Hysterese versehenen ersten Komparatorschaltung (K1) und an den Eingang einer zweiten Komparatorschaltung (K2) geschaltet ist,
**dadurch gekennzeichnet**, daß
die Flanken des Ausgangssignals (Uo1) der ersten Komparatorschaltung (K1) die Hysterese der ersten Komparatorschaltung (K1) zuschalten und die Flanken des Ausgangssignals (Uo2) der zweiten Komparatorschaltung (K2) diese Hysterese abschalten und die Hystereseumschaltung für die erste Komparatorschaltung (K1) mittels einer Schaltungsanordnung von Dioden (D1, D2), Flip-Flops (FF1, FF2) und Invertern (I1, I2) geschieht.

2. Schaltungsanordnung nach Anspruch 1, **dadurch gekennzeichnet**, daß die Flanken des Ausgangssignals (Uo) der einen Komparatorschaltung (K) über die Flip-Flops (FF1, FF2) die Hysterese dieser Komparatorschaltung (K) einschalten und daß die Flanken des Ausgangssignals (Uo) der anderen Komparatorschaltung (K) über die Flip-Flops (FF1, FF2) die Hysterese der ersten Komparatorschaltung (K) abschalten.

3. Schaltungsanordnung nach Anspruch 1, **dadurch gekennzeichnet**, daß mehrere phasenverschobene Eingangsspannungen (Ui1, Ui2, Ui3..) verwendet werden, welche in zyklischer Reihenfolge an die Eingänge von Komparatorschaltungen (K1, K2, K3..) geschaltet sind, und daß die Ausgangsspannungen (Uo1 , Uo2, Uo3 ..) die Hysterese der Komparatorschaltungen (K1, K2, K3..) jeweils einschalten und die Hysterese der zyklisch vorangehend angesteuerten Komparatorschaltungen -(K3, K1, K2..) jeweils abschalten.

## Claims

1. Circuit arrangement for producing rectangular shaped signals with the aid of a comparator circuit that is subject to a hysteresis effect and in which the hysteresis can be turned on and off, wherein the hysteresis is turned on during the zero crossings of the input signal and then turned off before the occurrence of the succeeding zero crossing and wherein an input signal (Ui) is connected to the input of a first comparator circuit (K1) that is provided with switchable hysteresis and to the input of a second comparator circuit (K2),
characterised in that,
the edges of the output signal (Uo1) from the first comparator circuit (K1) turn on the hysteresis of the first comparator circuit (K1) and the edges of the output signal (Uo2) from the second comparator circuit (K2) turn off this hysteresis and the switching over of the hysteresis for the first comparator circuit (K1) is brought about by means of a circuit arrangement of diodes (D1, D2), flip flops (FF1, FF2) and invertors (I1, I2).

2. Circuit arrangement in accordance with Claim 1,
characterised in that, the edges of the output signal (Uo) from the one comparator circuit (K) switch on the hysteresis of this comparator circuit (K) via the flip flops (FF1, FF2) and that the edges of the output signal (Uo) from the other comparator circuit (K) turn off the hysteresis of the first comparator circuit (K) via the flip flops (FF1, FF2).

3. Circuit arrangement in accordance with Claim 1,
characterised in that, there are used a plurality of phase displaced input voltages (Ui1, Ui2, Ui3, ..) which are connected in a cyclic sequence to the inputs of comparator circuits (K1, K2, K3, ..) and that the output voltages (Uo1, Uo2, Uo3, ..) respectively switch on the hysteresis of the comparator circuits (K1, K2, K3, ..) and respectively turn off the hysteresis of the cyclically preceding comparator circuits (K3, K1, K2, ..).

## Revendications

1. Circuit pour générer des signaux rectangulaires à partir de signaux sinusoïdaux à l'aide d'un circuit comparateur à hystérésis dont l'hystérésis peut être activée et annulée, sachant que l'hystérésis est connectée au moment des passages par zéro du signal d'entrée et déconnectée avant l'arrivée du passage par zéro suivant, et sachant qu'un premier signal d'entrée (Ui) est appliqué à un premier comparateur (K1) doté d'une hystérésis commutable, ainsi qu'à l'entrée d'un second comparateur (K2), circuit **caractérisé en ce que** les flancs du signal de sortie (Uo1) du premier comparateur (K1) connectent l'hystérésis dudit premier comparateur (K1) et que les flancs du signal de sortie (Uo2) du second comparateur (K2) déconnectent ladite hystérésis, et que la commutation de l'hystérésis est assurée au moyen d'un circuit composé de diodes (D1, D2), bascules (FF1, FF2) et inverseurs (I1, I2).

2. Circuit selon la revendication 1 **caractérisé en ce que** les flancs du signal de sortie (Uo) de l'un des comparateurs (K) activent l'hystérésis dudit comparateur (K) par l'intermédiaire des bascules (FF1, FF2) et que les flancs du signal de sortie (Uo) de l'autre comparateur (K) inhibent l'hystérésis du premier comparateur (K) grâce auxdites bascules (FF1, FF2).

3. Circuit selon la revendication 1 **caractérisé en ce que** plusieurs tensions d'entrées décalées en phase (Ui1, Ui2, Ui3, ...) sont utilisées, lesquelles sont appliquées aux entrées de comparateurs (K1, K2, K3, ...) dans un ordre cyclique, et que les tensions de sortie (Uo1, Uo2, Uo3, ...) connectent l'hystérésis des comparateurs respectifs (K1, K2, K3, ...) et déconnectent l'hystérésis des comparateurs (K3, K1, K2, ...) respectifs ayant précédé dans le cycle de commande.
